# EUROPÄISCHE PATENTSCHRIFT

(11) **EP 1 137 064 B1**
(45) Veröffentlichungstag und Bekanntmachung des Hinweises auf die Patenterteilung: **26.01.2005**
(21) Anmeldenummer: 01106952.3
(22) Anmeldetag: 20.03.2001
(51) Int. Cl.: H01L 23/467, G06F 1/20, H05K 7/20

(54) **Luftleithaube**
Air guiding hood
Système de guidage d'air

(30) Priorität: 21.03.2000 DE 10013863
(43) Veröffentlichungstag der Anmeldung: 26.09.2001
(73) Patentinhaber: Fujitsu Siemens Computers GmbH, 80807 München (DE)
(72) Erfinder: Müller-Augste, Frank, 86399 Bobingen (DE); Riebel, Michael, 86438 Kissing (DE)
(74) Vertreter: Epping Hermann & Fischer

(56) Entgegenhaltungen:
- DE-U- 29 518 201
- US-A- 5 297 005
- US-A- 5 630 469

## Beschreibung

Die Erfindung betrifft eine Luftleithaube an einem Kühlkörper zur Prozessorkühlung, wobei diese über den Kühlkörper gestülpt ist und mit einer Vorrichtung zur Erzeugung eines Luftstromes, wie z.B. einem Lüfter, verbunden ist.

Derartige Luftleithauben werden in PCs angewendet. Die Kühlkörper sind hierbei auf die Prozessoren aufgeklebt oder aufgeklammert und als Lüfter wird in der Regel der Lüfter im Netzteil verwendet. Die Luftleithaube wird an einem Ende über den Kühlkörper gestülpt und am anderen Ende am Gehäuse des Netzteiles eingehängt, so daß eine Luftführung zwischen Kühlkörper und Lüfter im Netzteil entsteht.

DE 295 18 201 U offenbart eine Wärmeableitungsvorrichtung für einen Computer, die eine ähnliche Luftleithaube enthält.

Um eine ideale Prozessorkühlung zu gewährleisten, muß der Spalt zwischen der Innenseite der Luftleithaube und der Außenseite des Kühlkörpers möglichst klein gehalten werden. Hierdurch wird die Strömung minimiert, welche ungenutzt an der Außenseite des Kühlkörpers vorbeizieht und gleichzeitig wird hierdurch die Strömungsgeschwindigkeit der Kühlluft im Kühlkörper erhöht.

Bei der Verwendung von Luftleithauben tritt das Problem auf, daß die Prozessoren auf dem Motherboard nicht millimetergenau relativ zum Lüfter beziehungsweise zum Netzteil plaziert sind.

Da die Luftleithauben kostengünstigerweise aus Kunststoff hergestellt und somit im wesentlichen starr sind und wie oben beschrieben exakt auf die Außenabmaße des Kühlkörpers abgestimmt sein müssen, sind aufgrund der Plazierungsunterschiede des Prozessors und somit des Kühlkörpers mehrere Luftleithauben notwendig, um die Plazierungsunterschiede auszugleichen.

Der Erfindung liegt daher die Aufgabe zugrunde, die gattungsgemäße Luftleithaube derart weiterzuentwickeln, daß trotz der Platzierungsunterschiede des Prozessors und somit des Kühlkörpers auf dem Motherboard stets die gleiche Luftleithaube verwendet werden kann.

Erfindungsgemäß wird diese Aufgabe dadurch gelöst, daß zwischen der Innenseite der Luftleithaube und der Außenseite des Kühlkörpers flexible Elemente angeordnet sind, welche den Spalt zwischen der Innenseite der Luftleithaube und der Außenseite des Kühlkörpers überbrücken.

Durch diese flexiblen Elemente kann der Querschnitt der Luftleithaube wesentlich größer ausgebildet werden und muß nicht mehr millimetergenau auf die Außenabmaße des Kühlkörpers abgestimmt sein. Die Platzierungsunterschiede werden durch die flexiblen Elemente in dem Spalt zwischen der Innenseite der Luftleithaube und der Außenseite des Kühlkörpers ausgeglichen.

Günstig ist es, an den flexiblen Elementen der Anlageseite zu dem Kühlkörper Aussparungen vorzusehen, so daß auch die Außenseite des Kühlkörpers mit einem Luftstrom, dessen Stärke durch die Aussparungen bestimmt wird, gekühlt wird.

Gemäß einer bevorzugten Ausführungsform sind die flexiblen Elemente über die ganzen Kantenlängen des Kühlkörpers ausgebildet. Ebenso ist es auch möglich, die flexiblen Elemente nicht über die ganzen Kantenlängen des Kühlkörpers auszubilden und durch die Beabstandung der flexiblen Elemente die Kühlung der Außenfläche des Kühlkörpers zu erzeugen.

Die flexiblen Elemente können einstückig mit der Luftleithaube hergestellt sein oder an einem in die Luftleithaube einsteckbaren Einsatz angeordnet sein.

Die Luftleithaube beziehungsweise der Einsatz besteht vorzugsweise aus hartem und die flexiblen Elemente aus weichem Kunststoff.

Zusätzlich oder alternativ ist es möglich, die flexiblen Elemente über ein Filmscharnier an der Luftleithaube beziehungsweise an dem Einsatz zu befestigen.

Vorzugsweise sind die flexiblen Elemente wie Klappen ausgebildet, deren freie Enden entgegen zur Aufsteckrichtung abgebogen sind. Hierdurch können diese je nach Größe des Spaltes zwischen Außenseite Kühlkörper und Innenseite der Luftleithaube entsprechend einklappen, wobei durch die abgebogenen freien Enden die Gefahr eines Verhakens ausgeschlossen wird.

Nachfolgend wird anhand eines in der Zeichnung dargestellten Ausführungsbeispiels die Erfindung näher erläutert.

In den Zeichnungen zeigen:
- Figur 1: eine Schrägansicht eines Motherboards mit einem auf dem Prozessor angeordnetem Kühlkörper, einem Netzteil sowie einer das Netzteil und den Kühlkörper verbindenden Luftleithaube,
- Figur 2: im Querschnitt den Kühlkörper mit darauf aufgesteckter Luftleithaube,
- Figur 3: den Schnitt A-A aus Figur 2,
- Figur 4: eine alternative Ausführungsform des Details Z aus Figur 3 in vergrößertem Maßstab,
- Figur 5: das Detail X aus Figur 2 und
- Figur 6: den Querschnitt gemäß Figur 2, mit an einem Einsatz angeordneten flexiblen Elementen.

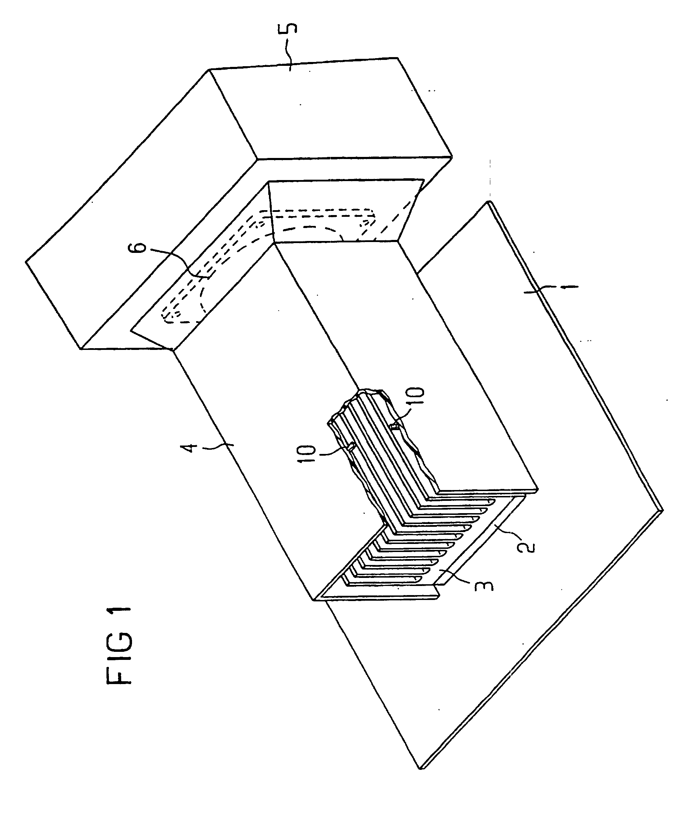

Figur 1 zeigt in einer perspektivischen Darstellung schematisch ein Motherboard 1 eines PCs, wobei auf dem Motherboard ein Prozessor 2 mit einer darauf angeordneten Kühlvorrichtung 3 befestigt ist.

Die Kühlvorrichtung 3 ist mit dem Prozessor 2 verklebt oder verklammert.

Über die Kühlvorrichtung 3 ist eine Luftleithaube 4 gestülpt, welche an ihrem anderen Ende an einem Netzteil 5 befestigt ist. An dem Netzteil 5 ist ein Lüfter 6 vorgesehen, welcher zum einen zur Kühlung des Netzteiles 5 und zum anderen über die Luftleithaube 4 und die Kühlvorrichtung 3 auch zur Kühlung des Prozessors 2 dient.

Die Luftleithaube 4 ist im Querschnitt U-förmig ausgebildet, kann jedoch auch nur in dem Bereich, in welchem sie über die Kühlvorrichtung 3 gestülpt ist, U-förmig und zwischen der Kühlvorrichtung 3 und dem Netzteil 5 geschlossen ausgebildet sein.

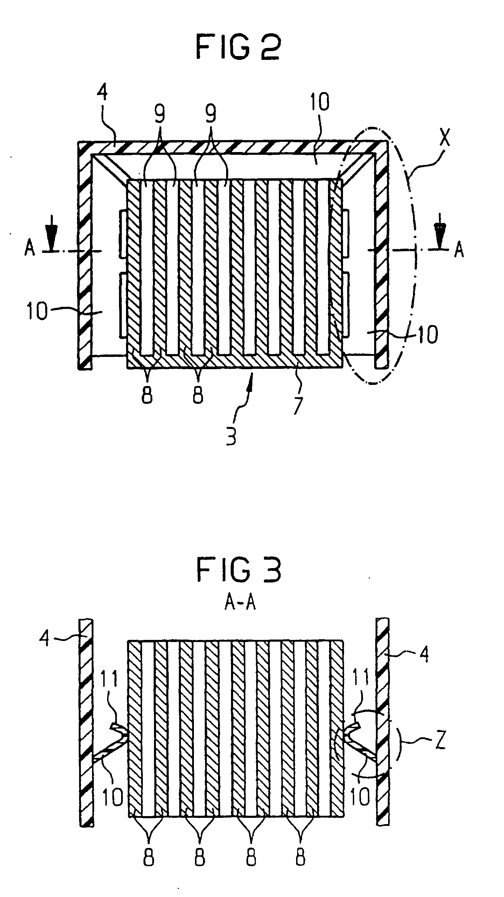

Figur 2 zeigt einen Querschnitt durch die Luftleithaube 4 und den Kühlkörper 3. Der Kühlkörper 3 besteht aus einem Basisabschnitt 7 und senkrecht darauf parallel angeordneten Rippen 8, deren Längserstreckung in Richtung aufgesteckter Luftleithaube 4 verläuft. Die Rippen 8 sind somit jeweils über einen Spalt 9 voneinander beabstandet.

Damit zwischen der Innenseite der Luftleithaube 4 und den Außenseiten der äußeren Rippen 8 beziehungsweise den Stirnseiten der Rippen 8 kein zu großer Luftspalt entsteht, durch welchen die Kühlluft nahezu ungenutzt vorbeiströmen würde, sind an den Innenseiten der Luftleithaube 4 flexible Elemente 10 angeordnet, welche den Luftspalt jeweils überbrücken und somit nahezu abdichten.

In Figur 3 ist der Schnitt A-A aus Figur 2 dargestellt.

Die flexiblen Elemente 10 sind klappenartig ausgebildet, und jeweils an ihrem freien Ende mit einer Abrundung 11 versehen. Beim Aufstecken der Luftleithaube 4 auf den Kühlkörper 3 können somit die flexiblen Elemente je nachdem wie der Kühlkörper relativ zur Luftleithaube 4 angeordnet ist, seitlich zur Luftleithaube 4 hin einklappen. Dies ist auch gut in dem teilweisen Ausbruch aus der Luftleithaube 4 in Fig. 1 zu erkennen.

Die flexiblen Elemente 10 sind aus weichem Kunststoff und die Luftleithaube 4 ist aus hartem-Kunststoff hergestellt. Der weiche Kunststoff übernimmt somit die Scharnierfunktion und erlaubt das seitliche Abklappen der flexiblen Elemente 10.

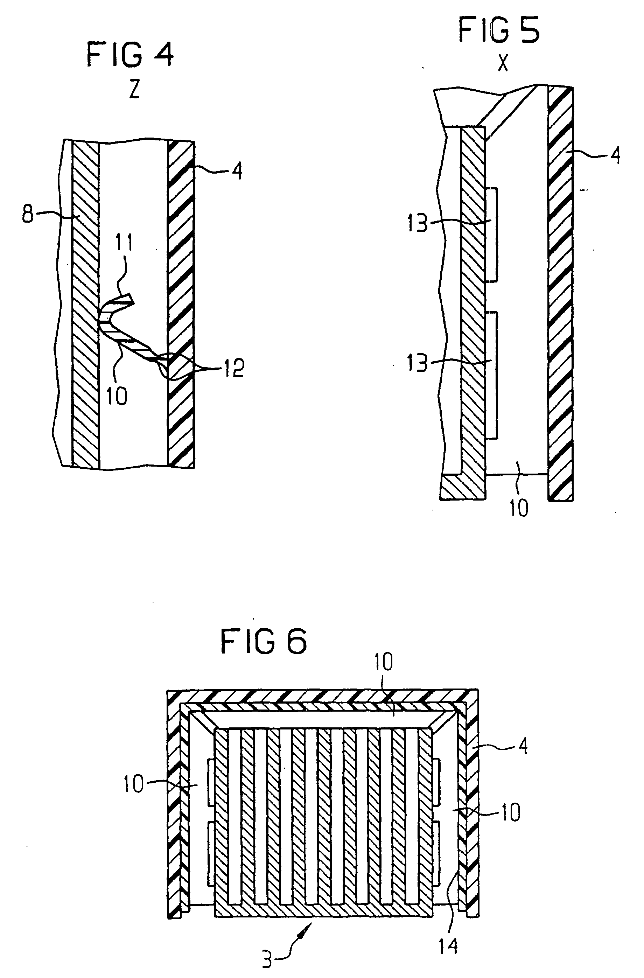

Figur 4 zeigt das Detail Z aus Figur 3 in einer alternativen Ausführungsform und im vergrößertem Maßstab. Bei dieser Ausführungsform ist zwischen den Klappen 10 und der Luftleithaube 4 ein Filmscharnier 12 durch beidseitige Einschnürungen im Querschnitt der Klappen 10 ausgebildet.

Durch das Filmscharnier wird die Scharnierfunktion an den Klappen 10 erleichtert.

Das Filmscharnier 12 kann alternativ oder in Kombination mit der Herstellung der flexiblen Elemente 10 aus weichem Kunststoff verwendet werden.

Wie in Figur 2 dargestellt, sind die flexiblen Elemente 10 sowohl an den Seitenwandungen der Luftleithaube 4 als auch an der Deckenwandung über die maximal mögliche Länge ausgebildet. An der Deckenwandung ist das flexible Element 10 etwas schmäler als die Breite der Deckenwandung ausgebildet, damit sich die flexiblen Elemente 10 der Seitenwandungen und der Deckenwandung im ausgeklappten Zustand nicht gegenseitig verhaken.

Um auch die Außenflächen der äußeren Kühlrippen 8 zu nutzen, sind an den seitlichen flexiblen Elementen 10 an ihren freien Enden Aussparungen 13 vorgesehen, welche somit nahezu unabhängig von der Schwenkposition der flexiblen Elemente 10 im Querschnitt genau definierte Kanäle bilden, durch welche die Kühlluft strömen kann. Figur 5 zeigt die Aussparungen 13 in vergrößerter Ansicht.

Die flexiblen Elemente 10 können, wie in den Figuren 1 bis 5 dargestellt, an der Luftleithaube 4 angeordnet sein, jedoch auch ebenso wie in Figur 6 dargestellt, an einem Einsatz 14 ausgebildet sein, der im Bereich des Kühlkörpers 3 in die Luftleithaube 4 eingesteckt wird.

## Patentansprüche

1. Luftleithaube (4) an einem Kühlkörper (3) zur Prozessor-Kühlung, wobei diese über den Kühlkörper (3) gestülpt ist und mit einer Vorrichtung zur Erzeugung eines Luftstroms, wie zum Beispiel einem Lüfter (6), verbunden ist,
**dadurch gekennzeichnet, daß**
zwischen der Innenseite der Luftleithaube (4) und der Außenseit des Kühlkörpers (3) flexible Elemente ..(10) angeordnet sind, welche den Spalt zwischen der Innenseite der Luftleithaube (4) und der Außenseite des Kühlkörpers (3) überbrücken.

2. Luftleithaube nach Anspruch 1,
**dadurch gekennzeichnet, daß**
die flexiblen Elemente (10) an der Anlageseite zu dem Kühlkörper (3) Aussparungen (13) aufweisen.

3. Luftleithaube nach Anspruch 1 oder 2,
**dadurch gekennzeichnet, daß**
die flexiblen Elemente (10) über nahezu die gesamte Kantenlänge des Kühlkörpers (3) ausgebildet sind.

4. Luftleithaube nach einem der Ansprüche 1 bis 3,
**dadurch gekennzeichnet, daß**
die flexiblen Elemente (10) klappenartig ausgebildet sind und ihre freien Enden eine Abrundung (11) aufweisen.

5. Luftleithaube nach einem der Ansprüche 1 bis 4,
**dadurch gekennzeichnet, daß**
die flexiblen Elemente (10) einstückig mit der Luftleithaube oder einstückig mit einem in die Luftleithaube eingesetzten Einsatz (14) hergestellt sind.

6. Luftleithaube nach Anspruch 5,
**dadurch gekennzeichnet, daß**
die Luftleithaube (4) und/oder der Einsatz (14) aus hartem Kunststoff und die flexiblen Elemente (10) aus weichem Kunststoff hergestellt sind.

7. Luftleithaube nach Anspruch 5 oder 6,
**dadurch gekennzeichnet, daß**
die flexiblen Elemente (10) über Filmscharniere (12) mit der Luftleithaube (4) beziehungsweise dem Einsatz (14) verbunden sind.

## Claims

1. Air guide shroud (4) on a heat sink (3) for processor cooling, the said air guide shroud being placed over the heat sink (3) and being connected to an apparatus for producing a flow of air, for example to a fan (6),
**characterized in that**
flexible elements (10) are arranged between the inner face of the air guide shroud (4) and the outer face of the heat sink (3) and bridge the gap between the inner face of the air guide shroud (4) and the outer face of the heat sink (3).

2. Air guide shroud according to Claim 1,
**characterized in that**
the flexible elements (10) have cutouts (13) on the bearing face which faces the heat sink (3).

3. Air guide shroud according to Claim 1 or 2,
**characterized in that**
the flexible elements (10) are formed over virtually the entire edge length of the heat sink (3).

4. Air guide shroud according to one of Claims 1 to 3,
**characterized in that**
the flexible elements (10) are in the form of flaps and their free ends have a rounded portion (11).

5. Air guide shroud according to one of Claims 1 to 4,
**characterized in that**
the flexible elements (10) are produced integrally with the air guide shroud or integrally with an insert (14) inserted into the air guide shroud.

6. Air guide shroud according to Claim 5,
**characterized in that**
the air guide shroud (4) and/or the insert (14) are/is produced from hard plastic and the flexible elements (10) are produced from soft plastic.

7. Air guide shroud according to Claim 5 or 6,
**characterized in that**
the flexible elements (10) are connected to the air guide shroud (4) or to the insert (14) by means of film hinges (12).

## Revendications

1. Capot de guidage d'air (4) sur un corps de refroidissement (3) pour le refroidissement d'un processeur, le capot de guidage d'air étant retourné pardessus le corps de refroidissement (3) et étant relié à un dispositif de génération d'un flux d'air, comme par exemple un ventilateur (6),
**caractérisé en ce que** des éléments flexibles (10) sont disposés entre le côté intérieur du capot de guidage d'air (4) et le côté extérieur du corps de refroidissement (3) et enjambent l'intervalle entre le côté intérieur du capot de guidage d'air (4) et le côté extérieur du corps de refroidissement (3).

2. Capot de guidage d'air selon la revendication 1, **caractérisé en ce que** les éléments flexibles (10) comportent des évidements (13) du côté où ils portent contre le corps de refroidissement (3).

3. Capot de guidage d'air selon la revendication 1 ou 2, **caractérisé en ce que** les éléments flexibles (10) sont constitués sur pratiquement toute la longueur des bords du corps de refroidissement (3).

4. Capot de guidage d'air selon l'une des revendications 1 à 3, **caractérisé en ce que** les éléments flexibles (10) sont constitués en volets et leurs extrémités libres comportent un arrondi (11).

5. Capot de guidage d'air selon l'une des revendications 1 à 4, **caractérisé en ce que** les éléments flexibles (10) sont réalisés d'une seule pièce avec le capot de guidage d'air ou d'une seule pièce avec une pièce d'insertion insérée dans le capot de guidage d'air.

6. Capot de guidage d'air selon la revendication 5, **caractérisé en ce que** le capot de guidage d'air (4) et/ou la pièce d'insertion (14) sont réalisés en matière plastique dure et les éléments flexibles sont réalisés en matière plastique souple.

7. Capot de guidage d'air selon la revendication 1 ou 6, **caractérisé en ce que** les éléments flexibles (10) sont reliés au capot de guidage d'air (4) respectivement la pièce d'insertion (14) par des charnières souples (12).
